Europäisches Patentamt

European Patent Office

Office européen des brevets

(19)

(11) EP 0 957 584 B1

(12) EUROPEAN PATENT SPECIFICATION

(45) Date of publication and mention
of the grant of the patent:
07.01.2004 Bulletin 2004/02

(51) Int Cl.⁷: **H03L 7/089**

(21) Application number: 98830300.4

(22) Date of filing: 15.05.1998

(54) **Phase locked loop circuit and control method thereof**

Phasenregelschleife und Verfahren zu deren Steuerung

Boucle à verrouillage de phase et son procédé de commande

(84) Designated Contracting States:
**DE FR GB IT**

(43) Date of publication of application:
**17.11.1999 Bulletin 1999/46**

(73) Proprietor: **STMicroelectronics S.r.l.**
**20041 Agrate Brianza (Milano) (IT)**

(72) Inventors:
• **Celant, Luca**
**20159 Milano (IT)**
• **Demicheli, Marco**
**22070 Binago (CO) (IT)**
• **Bruccoleri, Melchiorre**
**20017 Rho (MI) (IT)**
• **Ottini, Daniele**
**27100 Pavia (IT)**

(74) Representative: **Dini, Roberto, Dr. Ing.**
**Via Castagnole, 59**
**10060 None (Torino) (IT)**

(56) References cited:
**US-A- 5 736 880**

• **"DIFFERENTIAL CHARGE PUMP" IBM TECHNICAL DISCLOSURE BULLETIN., vol. 33, no. 9, 1 February 1991, page 332/333 XP000109567 NEW YORK US**
• **NOVOF I I ET AL: "FULLY INTEGRATED CMOS PHASE-LOCKED LOOP WITH 15 TO 240 MHZ LOCKING RANGE AND 50 PS JITTER" IEEE JOURNAL OF SOLID-STATE CIRCUITS., vol. 30, no. 11, 1 November 1995, pages 1259-1266, XP000553064 NEW YORK US**
• **THOMPSON B ET AL: "A 300-MHZ BICMOS SERIAL DATA TRANSCEIVER" IEEE JOURNAL OF SOLID-STATE CIRCUITS., vol. 29, no. 3, 1 March 1994, pages 185-192, XP000452105 NEW YORK US**

## Description

The present invention relates to a phase locked loop comprising a phase comparator, a charge pumping circuit, a loop filter and a voltage controlled oscillator, said charge pumping circuit comprising a plurality of current generators connected between the filter terminals and supply lines or ground nodes.

In electronic circuits it is often required to generate a highly precise reference frequency, whose value is programmable for various purposes. Read and write channels for Hard Disk Drives, i.e. the magnetic disks operating as mass storage memories for a processor, require eg. a circuit to generate a programmable reference frequency and maintain at constant density the data stored on the magnetic disk.

This function is commonly obtained through the use of phase locked loops or PLL, which generate a wide range of frequencies that can be set through the selection of the division value of two dividers, starting from a high precision fixed clock signal.

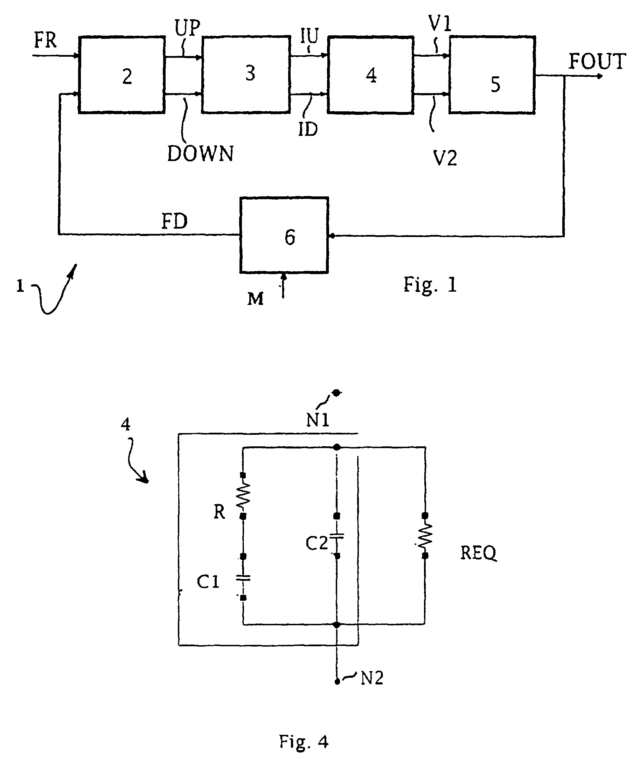

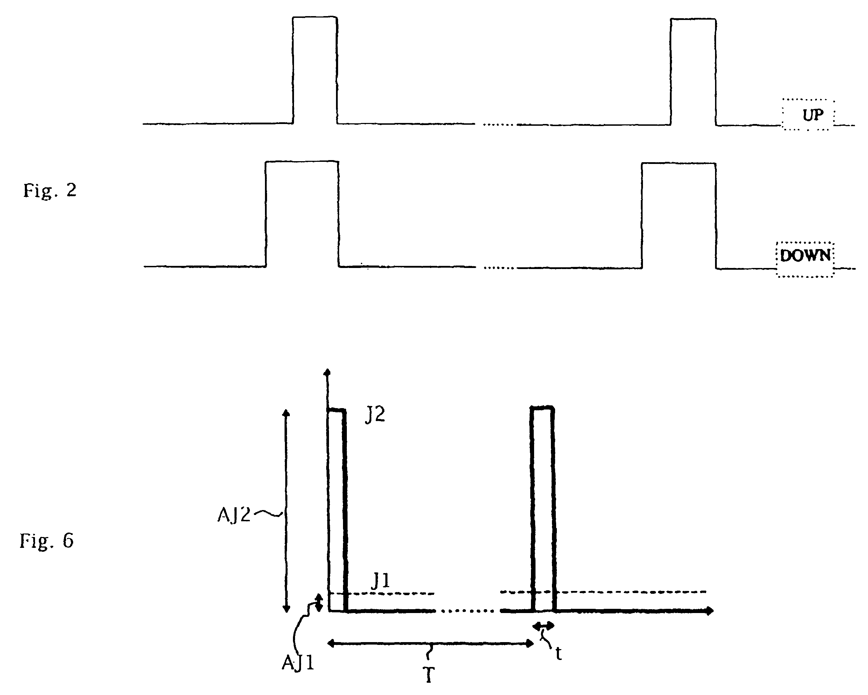

Figure 1 shows a block diagram of a phase locked loop 1 according to the state of art. The phase locked loop 1 comprises a phase comparator 2, a charge pumping loop 3, a filter loop 4 and a voltage controlled oscillator 5, connected in series on the main branch of the phase locked loop 1, whereas the feedback branch departs from the voltage controlled oscillator 5 drawing up an output frequency signal FOUT and provides a frequency divider block 6, which divides by an integer number M. The divided frequency signal FD is sent to the input of the phase comparator 2, which also receives a reference frequency signal FR. The phase comparator 2 detects the phase difference between the divided frequency signal FD and the reference frequency signal FR, issuing two signals UP and DOWN, which are representative of the phase error or displacement and whose trend is shown in Fig. 2. Signals UP and DOWN consist of pulses, whose length difference is proportional to the phase displacement between the divided frequency signal FD and the reference frequency signal FR. As it can be seen in Fig. 2, the signal UP is used to pull the signal DOWN to the low logic state, that is to drive its descending edge. The signal DOWN is pulled to the high logic state where it remains for a time proportional to the phase displacement, then the signal UP is generated, which remains at high logic level only for the time required by the logic gates to drivel the descending edge of both signals UP and DOWN. The phase comparator 2, also called sequential phase comparator, is particularly suited for those applications where input signals differ initially also in their frequency. Under steady conditions or when the divided frequency signal FD and the reference frequency signal FR are in phase , pulses are at their minimum length and have an equal length.

Both signals UP and DOWN drive the charge pumping circuit 3, that converts them in current pulses IU and ID. Current pulses IU and ID are then transformed in control voltage displacements V1 and V2 of the voltage controlled oscillator through the loop filter 4, which is a balanced filter RC as it will be better described with reference to figure 4. Said control voltages displacements V1 and V2 produce a change of the oscillating frequency of the voltage controlled oscillator 5, i. e. the frequency of the output frequency signal FOUT, which is proportional to the phase difference detected by the phase comparator 2 between the divided frequency signal FD and the reference frequency signal FR. Thus, the phase locked loop 1 in steady state will reach a condition where the raising edges or descending edges of the divided frequency signal FD and reference frequency signal FR are phase aligned, i.e. the phase error between them is zero.

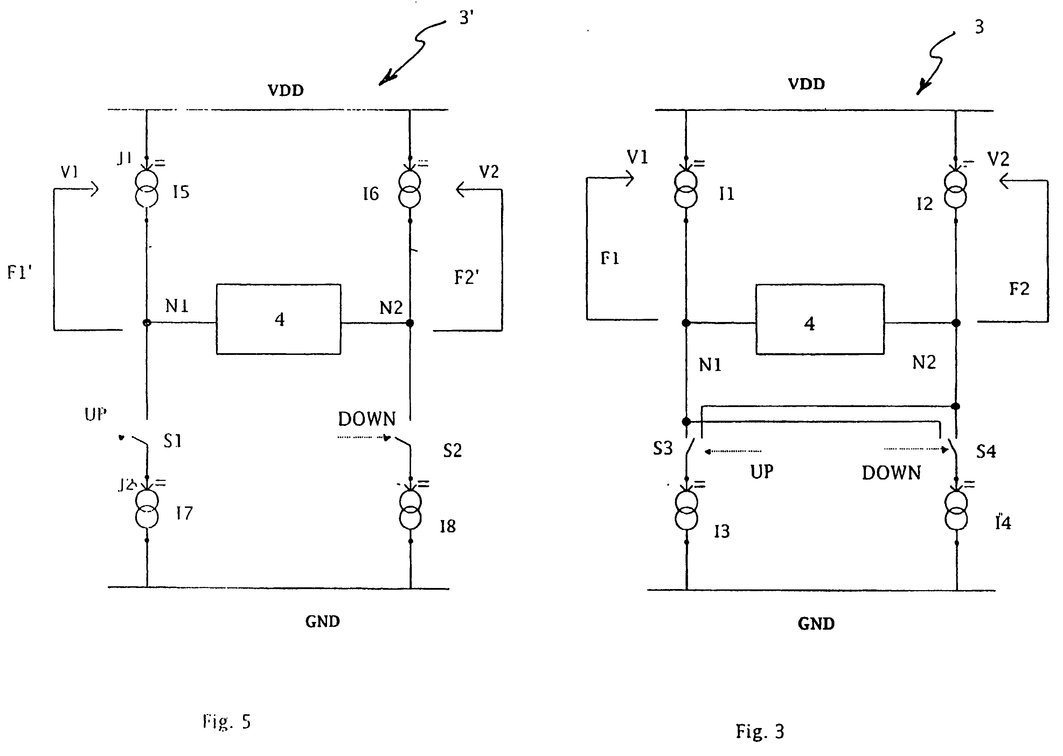

Figure 3 shows the charge pumping circuit 3 according to the state of art. As it can be seen, it includes two fixed current generators I1 and I2 located between a supply voltage VDD and each one of two nodes N1 e N2, respectively, which represent the terminals of the loop filter 4. Two further switching current generators I3 and 14 are connected between a ground node GND and nodes N1 and N2 through two respective switches S3 and S4.

Fixed current generators I1 and I2 are always operating so as to determine a constant current injection on nodes N1 and N2. Switches S3 and S4, driven by the signals UP and DOWN respectively, that are representative of the phase error, determine the connection with nodes N1 and N2 of the switching current generators I3 and I4 as follows: in a first configuration switching current generators I3 and I4 are connected with the node N2, whereas the node N1 will only receive the current supplied by the fixed current generator I1; in a second configuration, switching current generators I3 and I4 are connected with the node N1, whereas the node N2 will only receive the current supplied by the fixed current generator I2. Through the loop filter 4 action, that carryes out an integrating operation, voltage displacement will be established on nodes N1 and N2, which correspond to control voltages V1 and V2 of the voltage controlled oscillator 5. Moreover, a feedback path is provided to lead back control voltages V1 and V2 and drive the current output of fixed current generators I1 and I2. Thus, common mode voltage related to nodes N1 and N2 is maintained constant.

Substantially, the charge pumping circuit 3 provides two symmetric branches, each one of them comprising a constant current generator and a pulsed current generator, which inject their current in the nodes common to the filter and to the differential inputs of the voltage controlled oscillator. For this reason also the charge pumping circuit 3 can be considered as with two differential branches.

Figure 4 shows the loop filter 4; as mentioned above, this is a balanced filter RC, comprising a resistor R connected in series with a first capacitor C1 in parallel with a second capacitor C2. An equivalent resistor REQ is represented in parallel with the loop filter 4. Said equivalent resistor REQ represents the series resistance of fixed current generators I1 and I2. The loop filter 4 is specifically relevant as it determines the dynamics of the phase locked loop 1 and consequently its performances.

However, the kind of charge pumping circuit described above has a drawback. Since two current generators are always connected in parallel with the filter and having these current generators a non infinite resistance, a current flow will result between the input filter nodes with an ensuing undesired voltage displacement between the two points controlling the voltage controlled oscillator. As a result, the output signal from the phase locked loop is affected by a phase offset that cannot be removed from the reaction loop and will finally turn into a frequency output differing from the desired one.

A further drawback concerning the charge pumping circuit shown in figure 3 arises due to the fact that the switching current generators and switches are provided as a sole circuit comprising a differential couple of p-channel MOS transistors, which operate both as switches and current generators. The use of p-channel MOS transistors causes some problems due to the devices being slow and for the known difficulty of having two symmetric p-channel transistors.

A similar circuit is disclosed on IEEE Journal of Solid State Circuits, vol. 29. no. 3, 1 Mar. 1994, p. 185-192 "A 300 Mhz BiCMOS serial data transceiver", that disclose a BiCMOS circuit for serial data communications comprising PLL circuits. Said PLL, comprises a differential charge pump circuit, with common mode voltage feed-back to the constant current generators, that, in this case are obtained through current mirrors. The pulsed generators are driven by UP and DOWN signals for breaking the current injection steering current to or away from on-chip capacitors.

Also patent US 5 736 880 A, discloses a charge pump circuit according to the known prior art as depicted in fig. 3.

From the IBM Technical Disclosure Bulletin, vol. 33, no. 9, 1 Feb. 1991 p. 332/333, "Differential Charge Pumpit is known a charge pump circuit associated to a loop filter for use in a PLL it also known to make use of a differential structure, comprising constant current generators and DC current generators. The constant current generators receive the feedback signal from the nodes of the filter through a differential stage. A transistor operates as a switch driven by the DOWN (UP) signal so that it disconnects the filter every time that the DOWN signal is high.

Said transistor however is part of a differential pair with another transistor. This latter transistor connects the DC current generator to VDD, when the other disconnects the filter.

Under this frame,it is the main object of the present invention to indicate a phase locked loop equipped with a charge pumping circuit causing no input voltage displacements at the voltage controlled oscillator and determining a substantially zero phase offset.

It is a further object of the present invention to provide a phase locked loop equipped with a charge pumping circuit having a substantially infinite impedance with respect to the filter.

It is also a further object of the present invention to provide a phase locked loop equipped with switching current generators with a high parameter symmetry, which are little affected by any changes of the technological process parameters.

To reach these purposes it is the object of the present invention to provide a phase locked loop having the features described in the annexed claim 1. To reach such purposes, it is the object of the present invention to provide a phase locked loop incorporating the features of the annexed claims, which form an integral part of this description.

Further purposes, features and advantages of the present invention will become apparent from the following detailed description and annexed drawings, which are supplied by way of a non limiting example, where:

-    Figure 1 shows a block schematics of a phase locked loop according to the prior art;
-    Figure 2 shows the time diagram of two signals generated by the phase locked loop represented in Fig. 1;
-    Figure 3 shows a schematics of a detail of the phase locked loop represented in Fig. 1;
-    Figure 4 shows a schematics of a second detail of the phase locked loop represented in Fig. 1;
-    Figure 5 shows a schematics of a circuit detail of a phase locked loop according to the present invention;
-    Figure 6 shows a diagram of the waveforms generated by the circuit detail represented in Fig. 5;
-    Figure 7 shows an embodiment of the circuit detail represented in Fig. 5.

As it can be seen, Figure 5 shows a schematics of a charge pumping circuit 3' according to the present invention.

Said charge pumping circuit 3', according to Fig. 3, is connected with the filter loop 4 connected between nodes N1 and N2. A voltage driven current generator 15 is provided between the node N1 and the supply line VDD. Accordingly, a voltage driven current generator I6 is provided between the node N2 and the supply line VDD. The driving voltage consists of voltages V1 and V2 available on nodes N1 and N2 ledback through respective feedback paths F1 and F2. Thus, when driving the voltage driven current generators I5 and I6 a feedback control of the common mode voltage is achieved on nodes N1 and N2 of the loop filter 4.

A switched current generator I7 is connected between the node N1 and the ground node GND. Moreover, a switch S1, controlled by the signal UP, is connected between the node N1 and the switched current generator I7. Conformingly, a switched current generator I8 is connected between the node N2 and the ground node GND. Moreover, a switch S2, controlled by the signal DOWN, is connected between the node N2 and the switched current generator I8.

To maintain a constant common mode voltage related to nodes N1 and N2, the integral of a constant current J1 supplied by the voltage driven current generator I5 or I6 should be equal and of opposite sign to the integral of a pulsed current J2 supplied by the switched current generator I7 or I8. This, because the constant current J1 and the pulsed current J2 are integrated by the capacity represented by the capacitor C2 in the loop filter 4.

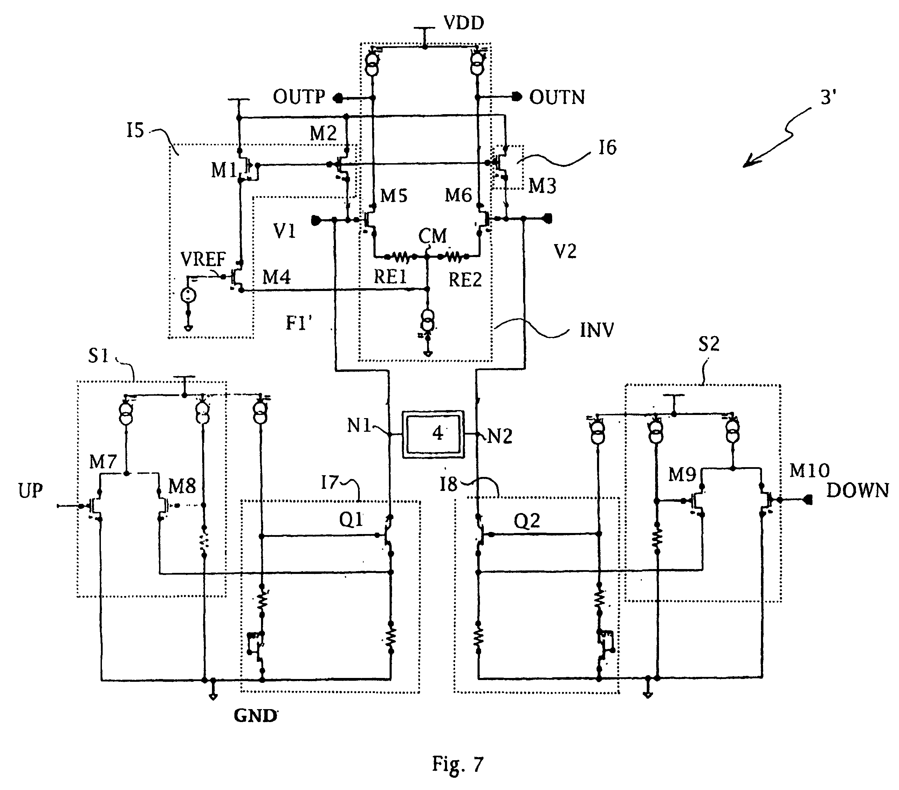

Therefore, in order to control the constant current J1 through the voltage to nodes N1 and N2 and maintain a constant common mode voltage in the charge pumping circuit 3', which comprises switches S1 and S2 instead of switches S3 and S3 shown in Fig. 3, it means that voltage driven current generators I5 and I6 have to supply a very low value constant current J1. As a result, also referring to Fig. 6 showing the trend of the constant current J1 and pulsed current J2, current amplitude AJ1 of the constant current J1 with respect to current amplitude AJ2 of the pulsed current J2 is:

$$AJ1 = AJ2 \times t/T$$

where T is the periodl of the signals UP and DOWN, t the time during which said signals UP and DOWN are at high level.

As it will be shown in the embodiment of Fig. 7, pulsed current amplitude AJ2 is typically 5 $\mu$A, the period T is 200 ns and the period t is 1 ns, so that current amplitude AJ1 will be 25 nA.

Voltage driven current generators I5 and I6 are provided through MOS transistors. Now, since the latter have to supply such a low current, they can be sized to provide a very high resistance with respect to nodes N1 and N2 and introduce a virtually zero phase offset.

Figure 7 shows a circuit embodiment of the charge pumping circuit 3' of Fig. 4, as provided based on BiCMOS technology. The charge pumping circuit 3' is represented connected with the loop filter 4 and with an input stage INV of the voltage controlled oscillator 5. Said input stage INV is substantially a transconductance amplifier.

The voltage controlled current generator I5 is provided through a p-channel MOS type transistor M2. The voltage controlled current generator I6 is provided through a p-channel MOS type transistor M3. Said transistors M2 are connected in parallel with a transistor M1 in a current mirror configuration.

Input stage INV is provided through a differential couple comprising two p-channel MOS type transistors M5 and M6, with differential output signals OUTP and OUTN drawn on their drain electrodes. Since OUTP and OUTN are transconductance amplifier outputs , they will be currents. The transistor M1 is connected with the common source electrode of transistors M5 and M6 through a transistor M4 controlled by a reference direct voltage VREF.

The transistor M4 has its own source electrode connected with the input stage INV, in particular with a node CM in common for the source electrodes of transistors M5 and M6 through their respective resistors RE1 and RE2, where, as known, the common mode voltage of input stage INV is available. As a result, the source voltage of the transistor M4 is proportional to the common mode voltage related to nodes N1 and N2 wherefrom it is modulated, modulating at the same time the current of the mirrors current circuits both transistors M2 and M3 are part of. Therefore, it can be said that there is a first feedback path F1' comprising the transistor M5, the transistor M4 and the current mirror including transistors M1 and M2, as well as a second feedback path F2' with the transistor M6, the transistor M4 and the current mirror including transistors M1 and M3.

Switched current generators I7 and I8 are provided through bipolar npn transistors Q1 and Q2. Emitter electrodes of said transistors Q1 and Q2 are controlled by their respective switches S1 and S2, whereas a constant current is supplied to the base electrodes of said transistors Q1 and Q2. The switch S1 comprises a differential couple of p-channel MOS type transistors M7 and M8. The signal UP will reach the gate electrode of the transistor M7. Since both the transistor M7 and transistor M8 are p-channel transistors, the signal UP is inverted before reaching the gate electrode, i.e. it is negated. The switch S2 comprises a differential couple of p-channel MOS type transistors M9 and M10. The signal DOWN, also negated like the signal UP, will reach the gate electrode of the transistor M9.

The electric circuit shown in Fig. 7 carries out the functions explained with reference to Fig. 5.

The features of the present invention will result apparent from the above description while its advantages are also clear.

The phase locked loop according to the present invention provides advantageously an extremely high resistance to the loop filter. This is obtained by the use of simple switches controlled by the signals proportional to the phase displacement from the phase comparator, said switches taking advantage of the fact that a feedback path will maintain a constant common mode voltage to the loop filter terminals and impose equality to the currents integral of fixed generators and switched generators. Thus, the current of fixed generators can be very small while the transistors embodying said generators can be sized for providing an extremely high resistance. Consequently, the problem of a phase offset introduced by the charge pumping circuit is removed.

Moreover, sizing is advantageously improved through the use of current mirrors for fixed generators. Current mirrors, in fact, require MOS transistors with a narrow long channel, which obviously offer a high resistance.

A further advantage of the phase locked loop according to the present invention is the use of breaking switches instead of commuting switches, which allows for providing switching current generators embodied through bipolar npn transistors, that are easily obtainable according to BiCMOS technology. This ensures a high symmetry level between the two differential branches, as well as fast switching transistors. Moreover, the circuit is also less affected by any changes of the technological process parameters.

**Claims**

1. A phase locked loop, comprising a phase comparator, a charge pumping circuit, a loop filter and a voltage controlled oscillator, wherein the loop filter has two input terminals connected with two symmetric branches of the charge pumping circuit, each symmetric branch comprising a constant current generator and a pulsed current generator, where feedback paths are provided to control constant current generators through the voltage available on both loop filter terminals, **characterized in that** pulsed current generators (I7, I8) are separated from the respective loop filter terminals (N1, N2) through circuit breaking switching means (S1, S2), said circuit breaking switching means (S1, S2) being controlled by phase error signals (UP, DOWN) from the phase comparator (2).

2. A phase locked loop according to claim 1, **characterized in that** constant current generators (I5, I6) are provided through current mirror circuits (M1, M2, M4; M1, M3, M4).

3. A phase locked loop according to claim 1, **characterized in that** constant current generators (I5, I6) are controlled through a common mode signal drawn by a node (CM) of a stage (INV) belonging to the voltage controlled oscillator (5) and led to said constant current generators (I5, I6) through feedback paths (F1', F2').

4. A phase locked loop according to claims 2 and 3, **characterized in that** feedback paths (F1', F2') modulate the current of a current generator (M4) belonging to the current mirrors (M1, M2, M4; M1, M3, M4).

5. A phase locked loop according to claim 1, **charac-**

**terized in that** pulsed generators (I7, I8) are provided through bipolar npn transistors (Q1, Q2).

6. A phase locked loop according to claim 5, **characterized in that** switch means (S1, S2) are provided through differential MOS transistor couples (M7, M8; M9, M10)

7. A control method of a charge pumping circuit in a phase locked loop, where a phase comparator supplies phase error signals to the charge pumping circuit, which converts them in current signals integrated by a loop filter to drive a voltage controlled oscillator, where the charge pumping circuit is provided in two symmetric branches, each branch comprising a constant current generator and a pulsed current generator, providing for the control of constant current generators through feedback paths apt to maintain a constant common mode voltage on two loop filter terminals, **characterized in that** each pulsed current generator (I7, I8) is separated from the respective loop filter terminals (N1, N2) through circuit breaking switching means (S1, S2), said circuit breaking switching means (S1, S2) being controlled by a transition of the corresponding phase error signal (UP, DOWN) from the phase comparator.

8. A control method of a charge pumping circuit in a phase locked loop according to claim 7, **characterized in that** said transition of the corresponding phase error signal (UP, DOWN) occurs from the low logic level to the high logic level.

9. A control method of a charge pumping circuit in a phase locked loop according to claim 7, **characterized in that** connection between each pulsed current generator (I7, I8) with the respective terminal (N1, N2) of the loop filter (4) is interrupted during the opposite transition of the corresponding phase signal (UP, DOWN).

10. A control method of a charge pumping circuit in a phase locked loop according to claim 7, **characterized in that** constant current generators (I5, I6) are sized to supply a first current (J1) with a first current amplitude (AJ1) substantially proportional to a second amplitude (AJ2) of a second current (J2) supplied by the pulsed current generators (I7, I8) through the ratio of a period (T) of the phase error signals (UP, DOWN) to a time interval (t), during which each one of said phase error signals (UP, DOWN) is at high logic level or at low logic level should said phase signals (UP, DOWN) be negated.

11. A control method of a charge pumping circuit in a phase locked loop according to claim 9, **characterized in that** current mirrors (M1, M2, M4; M1, M3, M4) are used to provide constant current generators (I5, I6).

## Patentansprüche

1. Phasenregelkreis, der einen Phasenkomparator, einen Schaltkreis zum Pumpen von Ladungen, ein Regelkreisfilter und einen spannungsgesteuerten Oszillator aufweist, wobei das Regelkreisfilter zwei Eingangsanschlüsse aufweist, die mit zwei symmetrischen Zweigen des Schaltkreises zum Pumpen von Ladungen verbunden sind, wobei jeder symmetrische Zweig einen Generator für konstanten Strom und einen Generator für gepulsten Strom aufweist, wobei Rückkopplungspfade vorgesehen sind, um die Generatoren für konstanten Strom über die Spannung zu steuern, die an beiden Regelkreisfilteranschlüssen bereitsteht, **dadurch gekennzeichnet, dass** Generatoren (I7, I8) für gepulsten Strom von den jeweiligen Regelkreisfilteranschlüssen (N1, N2) durch Schaftkreisunterbrechungsschaltmittel (S1, S2) getrennt sind, wobei diese Schalkreisunterbrechungsschaltmittel (S1, S2) durch Phasenfehlersignale (UP, DOWN) von dem Phasenkomparator (2) gesteuert sind.

2. Phasenregelkreis nach Anspruch 1, **dadurch gekennzeichnet, dass** die Generatoren (I5, I6) für konstanten Strom durch Stromspiegelschaltungen (M1, M2, M4; M1, M3, M4) bereitgestellt sind.

3. Phasenregelkreis nach Anspruch 1, **dadurch gekennzeichnet, dass** die Generatoren (15, 16) für konstanten Strom durch ein Signal eines gemeinsamen Modus gesteuert werden, das von einem Knoten (CM) einer Stufe (INV) abgegriffen wird, die zu dem spannungsgesteuerten Oszillator (5) gehört, und über Rückkopplungspfade (F1', F2'), zu den Generatoren (I5, I6) für konstanten Strom geführt werden.

4. Phasenregelkreis nach Anspruch 2 oder 3, **dadurch gekennzeichnet, dass** die Rückkopplungspfade (F1', F2') den Strom eines Stromgenerators (M4) modulieren, der zu den Stromspiegeln (M1, M2, M4; M1, M3, M4) gehört.

5. Phasenregelkreis nach Anspruch 1, **dadurch gekennzeichnet, dass** die gepulsten Generatoren (I7,I8) durch bipolare npn-Transistoren (Q1, Q2) bereitgestellt sind.

6. Phasenregelkreis nach Anspruch 5, **dadurch gekennzeichnet, dass** die Schaltmittel (S1, S2) durch Differenzial-MOS-Transistorpaare (M1, M2; M9, M10) bereitgestellt sind.

7. Steuerungsverfahren für einen Schaltkreis zum Pumpen von Ladungen in einem Phasenregelkreis, wobei ein Phasenkomparator dem Schaltkreis zum Pumpen von Ladungen Phasenfehlersignale bereitstellt, der sie in Stromsignale konvertiert, die mittels eines Regelkreisfilters integriert sind, um einen spannungsgesteuerten Oszillator anzusteuern, wobei der Schaltkreis zum Pumpen von Ladungen durch zwei symmetrische Zweige bereitgestellt ist, wobei jeder Zweig einen Generator für konstanten Strom und einen Generator für gepulsten Strom aufweist, die für die Steuerung der Generatoren für konstanten Strom durch Rückkopplungspfade bereitgestellt sind, die ausgebildet sind, um an zwei Regelkreisfilteranschlüssen eine konstante Spannung eines gemeinsamen Modus aufrechtzuerhalten, **dadurch gekennzeichnet, dass** jeder Generator (I7, I8) für gepulsten Strom durch Schaltkreisunterbrechungsschaltmittel (S1, S2) von den jeweiligen Regelkreisfilteranschlüssen (N1, N2) getrennt ist, wobei die Stromkreisunterbrechungsschaltmittel (S1, S2) von einem Übergang des entsprechenden Phasenfehlersignals (UP, DOWN) von dem Phasenkomparator gesteuert werden.

8. Steuerungsverfahren eines Schaltkreises zum Pumpen von Ladungen in einem Phasenregelkreis gemäß Anspruch 7, **dadurch gekennzeichnet, dass** der Übergang des entsprechenden Phasenfehlersignals (UP, DOWN) von dem niedrigen Logikniveau zu dem hohen Logikniveau auftritt.

9. Steuerungsverfahren eines Schaltkreises zum Pumpen von Ladungen in einem Phasenregelkreis gemäß Anspruch 7, **dadurch gekennzeichnet, dass** eine Verbindung zwischen jedem Generator (17, 18) für gepulsten Strom mit dem jeweiligen Anschluss (N1, N2) des Regelkreisfilters (4) während des umgekehrten Übergangs des entsprechenden Phasensignals (UP, DOWN) unterbrochen wird.

10. Steuerungsverfahren für einen Schaltkreis zum Pumpen von Ladungen in einem Phasenregelkreis gemäß Anspruch 7, **dadurch gekennzeichnet, dass** Generatoren (I5, I6) für konstanten Strom derart bemessen sind, um einen ersten Strom (J1) mit einer ersten Stromamplitude (AJ1) bereitzustellen, der im wesentlichen proportional zu einer zweiten Amplitude (AJ2) eines zweiten Stroms (J2) ist, der von den Generatoren (I7, I8) des gepulsten Stromes durch das Verhältnis einer Periode (T) des Phasenfehlersignals (UP, DOWN) zu einem Zeitintervall (t) bereitgestellt wird, während dem jedes der Phasenfehlersignale (UP, DOWN) sich auf einem hohen Logikniveau oder einem niedrigen Logikniveau befindet, sollten die Phasensignale (UP; DOWN) negiert werden.

**11.** Steuerungsverfahren eines Schaltkreises zum Pumpen von Ladungen in einem Phasenregelkreis gemäß Anspruch 9, **dadurch gekennzeichnet, dass** Stromspiegel (M1, M2, M4; M1, M3, M4) verwendet werden, um die Generatoren (I5, I6) für konstanten Strom bereitzustellen.

**Revendications**

**1.** Boucle à verrouillage de phase, comprenant un comparateur de phase, un circuit de pompage de charge, un filtre à boucle et un oscillateur commandé en tension, dans laquelle le filtre à boucle comporte deux bornes d'entrée connectées à deux branches symétriques du circuit de pompage de charge, chaque branche symétrique comportant un générateur de courant constant et un générateur de courant à impulsions, où des trajets de rétroaction sont disposés pour commander les générateurs de courant constant au moyen de la tension disponible sur les deux bornes du filtre à boucle, **caractérisée en ce que** les générateurs de courant à impulsions (I7, I8) sont séparés des bornes du filtre à boucle (N1, N2) respectives par des moyens de commutation et de coupure de circuit (S1, S2), lesdits moyens de commutation et de coupure de circuit (S1, S2) étant commandés par les signaux d'erreur de phase (UP, DOWN) issus du comparateur de phase (2).

**2.** Boucle à verrouillage de phase selon la revendication 1, **caractérisée en ce que** les générateurs de courant constant (I5, I6) sont constitués de circuits à miroirs de courant (M1, M2, M4 ; M1, M3, M4).

**3.** Boucle à verrouillage de phase selon la revendication 1, **caractérisée en ce que** les générateurs de courant constant (I5, I6) sont commandés au moyen d'un signal de mode commun tiré par un noeud (CM) d'un étage (INV) appartenant à l'oscillateur commandé en tension (5) et dirigé vers lesdits générateurs de courant constant (I5, I6) par les trajets de rétroaction (F1', F2').

**4.** Boucle à verrouillage de phase selon les revendications 2 et 3, **caractérisée en ce que** les trajets de rétroaction (F1', F2') modulent le courant d'un générateur de courant (M4) appartenant aux miroirs de courant (M1, M2, M4 ; M1, M3, M4).

**5.** Boucle à verrouillage de phase selon la revendication 1, **caractérisée en ce que** les générateurs à impulsions (I7, I8) sont constitués de transistors NPN bipolaires (Q1, Q2).

**6.** Boucle à verrouillage de phase selon la revendication 5, **caractérisée en ce que** les moyens de commutation (S1, S2) sont constitués de couples de transistors MOS différentiels (M7, M8 ; M9, M10).

**7.** Procédé de commande d'un circuit de pompage de charge dans une boucle à verrouillage de phase, dans lequel un comparateur de phase fournit des signaux d'erreur de phase au circuit de pompage de charge, qui les convertit en signaux de courant intégrés par un filtre à boucle pour piloter un oscillateur commandé en tension, où le circuit de pompage de charge est muni de deux branches symétriques, chaque branche comprenant un générateur de courant constant et un générateur de courant à impulsions, assurant la commande des générateurs de courant constant au moyen de trajets de rétroaction aptes à maintenir une tension de mode commun constante sur deux bornes du filtre à boucle, **caractérisé en ce que** chaque générateur de courant à impulsions (I7, I8) est séparé des bornes du filtre à boucle (N1, N2) respectives par des moyens de commutation et de coupure de circuit (S1, S2), lesdits moyens de commutation et de coupure de circuit (S1, S2) étant commandés par une transition du signal d'erreur de phase (UP, DOWN) correspondant issu du comparateur de phase.

**8.** Procédé de commande d'un circuit de pompage de charge dans une boucle à verrouillage de phase selon la revendication 7, **caractérisé en ce que** ladite transition du signal d'erreur de phase (UP, DOWN) correspondant se produit du niveau logique bas au niveau logique haut.

**9.** Procédé de commande d'un circuit de pompage de charge dans une boucle à verrouillage de phase selon la revendication 7, **caractérisé en ce que** la connexion entre chaque générateur de courant à impulsions (I7, I8) avec la borne (N1, N2) respective du filtre à boucle (4) est interrompue pendant la transition opposée du signal de phase (UP, DOWN) correspondant.

**10.** Procédé de commande d'un circuit de pompage de charge dans une boucle à verrouillage de phase selon la revendication 7, **caractérisé en ce que** les générateurs de courant constant (I5, I6) sont dimensionnés pour fournir un premier courant (J1) avec une première amplitude de courant (AJ1) sensiblement proportionnelle à une deuxième amplitude (AJ2) d'un deuxième courant (J2) fourni par les générateurs de courant à impulsions (I7, I8) par le rapport d'une période (T) des signaux d'erreur de phase (UP, DOWN) à un intervalle de temps (t), pendant lequel chacun desdits signaux d'erreur de phase (UP, DOWN) est au niveau logique haut ou au niveau logique bas si lesdits signaux de phase (UP, DOWN) devaient être inversés.

**11.** Procédé de commande d'un circuit de pompage de charge dans une boucle à verrouillage de phase selon la revendication 9, **caractérisé en ce qu'**on utilise des miroirs de courant (M1, M2, M4 ; M1, M3, M4) pour constituer des générateurs de courant constant (I5, I6).

FR → [2] — UP → [3] — IU → [4] — V1 → [5] → FOUT

DOWN — ID — V2

FD — [6] — M

1

Fig. 1

4

N1

R

C1

C2

REQ

N2

Fig. 4

Fig. 2

UP

DOWN

Fig. 6

J2

J1

AJ1

AJ2

T

t

Fig. 5

Fig. 3

EP 0 957 584 B1

Fig. 7